# EUROPEAN PATENT SPECIFICATION

(11) **EP 3 342 600 B1**
(45) Date of publication and mention of the grant of the patent: **16.10.2019**
(21) Application number: 17200058.0
(22) Date of filing: 06.11.2017
(51) Int. Cl.: B42D 15/02, B42D 15/04

(54) **FOLDING ELECTRONIC CARD WITH SECURED SWITCH CONNECTION**
ELEKTRONISCHE FALTKARTE MIT GESICHERTER SCHALTVERBINDUNG
CARTE ÉLECTRONIQUE PLIABLE À CONNEXION DE COMMUTATEUR SÉCURISÉE

(30) Priority: 30.12.2016 CN 201621494312 U
(43) Date of publication of application: 04.07.2018
(73) Proprietor: Shenzhen Winpsheng Craft Company Limited, ShenZhen, Guangdong (CN)
(72) Inventor: SUN, Jingyun, Shenzhen, Guangdong (CN)
(74) Representative: Sun, Yiming

(56) References cited:
- DE-U1- 8 300 256

## Description

### FIELD OF THE TECHNOLOGY

The present disclosure relates to an electronic product, and more particularly to an electronic card with secured switch connection which can prevent displacement of the insulation sheet in the card.

In particular the invention relates to a folding electronic card with secured switch connection, comprising a circuit board and an insulation sheet.

### BACKGROUND

An electronic card is mainly used as a celebration gift in festival such as birthday. When the card is opened, sweet blessing music will be played. The switch mechanism of a traditional electronic card mainly relies on pulling or sliding of a PVC film out of metal elastic sheet to trigger a circuit. The structure is simple. However, there is a potential problem. When the opening angle of the card is too wide, the PVC film may pop up to the surface of the metal elastic sheet, and can no longer be moved along a normal track, resulting in a defective product.

DE 83 00 256 U1 discloses a greeting card according to the preamble of claim 1 and with at least two card pages hinged around a common fold line, wherein in addition to two sides of a foldable cardboard a cover page is provided on the inside of one of the two folding carton sides, and an electronic music work and a switch for triggering the music work depending on the folding of the cardboard sides to each other or from each other are provided in the interior between the cover page and the associated cardboard side. The switch has a breaker comprising a plastic strip which is hinged over the folding line on the inside of the uncovered cardboard side.

### SUMMARY

In order to overcome the drawbacks of the prior art, it is an object of the present application to provide a folding electronic card with secured switch connection which can prevent displacement of the insulation sheet in the card.

The folding electronic card with secured switch connection is achieved by the following technical measures. A folding electronic card with secured switch connection, including a circuit board and an insulation sheet; a contact plate and a elastic sheet provided on the circuit board and acting as a switch, the elastic sheet resiliently being pressed against the contact plate, the insulation sheet being slidable between the contact plate and the elastic sheet; a U-shaped snap-engaging sleeve provided on the circuit board and located above the contact plate and the elastic sheet, the insulation sheet being slidably inserted in the U-shaped snap-engaging sleeve, one end of the insulation sheet being provided with a through hole, the circuit board and a fixed end of the insulation sheet being fixed on two sides of the folding electronic card respectively; and when the folding electronic card is unfolded, a movable end of the insulation sheet slides so that the contact plate and the elastic sheet are in contact at the through hole, and when the card is folded, the movable end of the insulation sheet slides between the contact plate and the elastic sheet so that the contact plate and the elastic sheet are insulated from each other by the insulation sheet.

In a preferred embodiment, the circuit board is provided with two engaging openings on two opposite sides of the contact plate respectively, and the U-shaped snap-engaging sleeve is snap-engaged on the circuit board through the engaging openings.

In a preferred embodiment, the insulation sheet is a PVC film.

In a preferred embodiment, the circuit board is further provided with a button battery and a speaker.

In a preferred embodiment, a hollow is provided at a position of the U-shaped snap-engaging sleeve corresponding to the contact plate.

The insulation sheet of the present disclosure is inserted in the U-shaped snap-engaging sleeve. When the insulation sheet is in the pulling or sliding process, it cannot be popped out from the metal elastic sheet due to the function of the U-shaped snap-engaging sleeve. The insulation sheet must move along the direction of the confined space defined by the U-shaped snap-engaging sleeve. This ensures that the insulation sheet cannot fall out during the sliding process, and can only slide along a fixed direction. The structure is simple and practical. It can reduce the defect rate in actual production. The production process is simple, and the production cost can be reduced while reducing the defect rate.

### BRIEF DESCRIPTION OF THE DRAWINGS

Fig. 1 is an exploded schematic view of an embodiment of the electronic card with secured switch connection.
Fig. 2 is a schematic view of an embodiment of the electronic card with secured switch connection.

### DETAILED DESCRIPTION

The folding electronic card with secured switch connection of the present application will now be described in further detail with reference to the accompanying drawings.

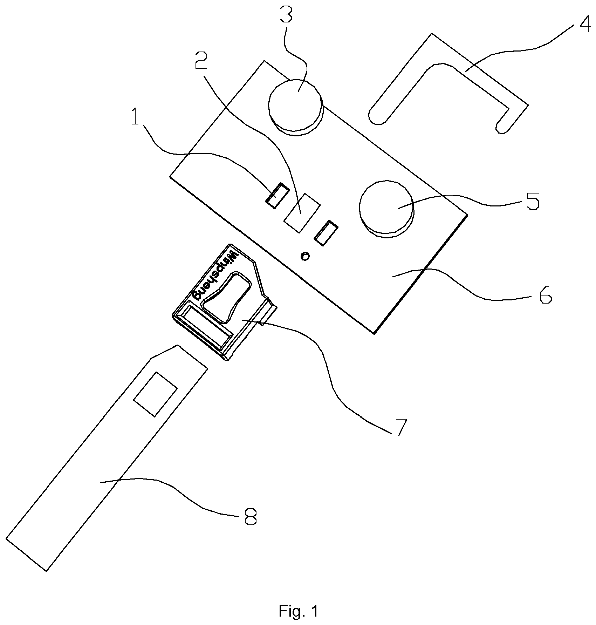

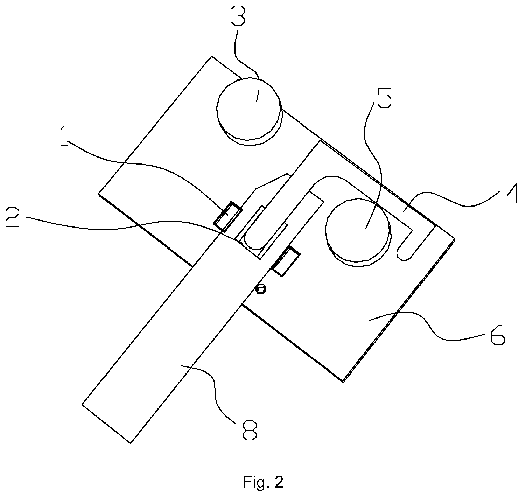

A folding electronic card with secured switch connection, as shown in Figs. 1 and 2, may include a circuit board 6 and an insulation sheet 8. A contact plate 2 and an elastic sheet 4, together acting as a switch, may be provided on the circuit board 6. The elastic sheet 4 can be resiliently pressed against the contact plate 2. The insulation sheet 8 can be slidable between the contact plate 2 and the elastic sheet 4. A U-shaped snap-engaging sleeve 7 may be provided on the circuit board 6 and may be located above the contact plate 2 and the elastic sheet 4. The insulation sheet 8 can be slidably inserted in the U-shaped snap-engaging sleeve 7. One end of the insulation sheet 8 may be provided with a through hole. The circuit board 6 and a fixed end of the insulation sheet 8 may be fixed on two sides of a folding electronic card respectively. When the card is unfolded, a movable end of the insulation sheet 8 slides so that the contact plate 2 and the elastic sheet 4 are in contact with each other at the through hole. When the card is folded, the movable end of the insulation sheet 8 slides between the contact plate 2 and the elastic sheet 4 so that the contact plate 2 and the elastic sheet 4 are insulated from each other by the insulation sheet 8.

The insulation sheet 8 of the present disclosure can be inserted in the U-shaped snap-engaging sleeve 7. When the insulation sheet 8 is in the pulling or sliding process, it cannot be popped out from the metal elastic sheet 4 due to the function of the U-shaped snap-engaging sleeve 7. The insulation sheet 8 must move along the direction of the confined space defined by the U-shaped snap-engaging sleeve 7. This can ensure that the insulation sheet 8 cannot fall out during the sliding process, and can only slide along a fixed direction. The structure is simple and practical. It can reduce the defect rate in actual production. The production process is simple, and the production cost can be reduced while reducing the defect rate.

In the embodiment of the electronic card with secured switch connection, shown in Figs. 1 and 2 and based on the above-mentioned technical scheme, the circuit board 6 may be provided with two snap-engaging openings 1 on two opposite sides of the contact plate 2 respectively. The U-shaped snap-engaging sleeve 7 can be snap-engaged on the circuit board 6 through the snap-engaging openings 1. This can facilitate production and processing.

In the embodiment of the electronic card with secured switch connection, shown in Figs. 1 and 2 and based on the above-mentioned technical scheme, the insulation sheet 8 can be a PVC film.

In the embodiment of the electronic card with secured switch connection, shown in Figs. 1 and 2 and based on the above-mentioned technical scheme, the circuit board 6 may be further provided with a button battery 5 and a speaker 3. In other embodiments, the circuit board 6 may be further provided with LED lights.

In the embodiment of the electronic card with secured switch connection, shown in Figs. 1 and 2 and based on the above-mentioned technical scheme, a hollow may be provided at a position of the U-shaped snap-engaging sleeve 7 corresponding to the contact plate 2. This can facilitate a person to check whether the assembly is in place during processing and using of the product.

The above is a description that assists the understanding of the electronic card with secured switch connection of the present application. The embodying of the electronic card with secured switch connection of the present application is not limited by the above-described embodiments, but only by the scope of protection of the appended claims.

## Claims

1. A folding electronic card with secured switch connection, comprising a circuit board (6) and an insulation sheet (8); further comprising a contact plate (2) and an elastic sheet (4) provided on the circuit board (6) and acting as a switch, the elastic sheet (4) resiliently pressed against the contact plate (2), the insulation sheet (8) being slidable between the contact plate (2) and the elastic sheet (4); the folding electronic card being **characterised by** further comprising a U-shaped snap-engaging sleeve (7) provided on the circuit board (6) and located above the contact plate (2) and the elastic sheet (4), the insulation sheet (8) being slidably inserted in the U-shaped snap-engaging sleeve (7), one end of the insulation sheet (8) being provided with a through hole, the circuit board (6) and a fixed end of the insulation sheet (8) being fixed on two sides of the folding electronic card respectively; and when the folding electronic card is unfolded, a movable end of the insulation sheet (8) slides so that the contact plate (2) and the elastic sheet (4) are in contact with each other at the through hole, and when the card is folded, the movable end of the insulation sheet (8) slides between the contact plate (2) and the elastic sheet (4) so that the contact plate (2) and the elastic sheet (4) are insulated from each other by the insulation sheet (8).

2. The folding electronic card with secured switch connection according to claim 1, wherein the circuit board (6) is provided with two snap-engaging openings (1) on two opposite sides of the contact plate (2) respectively, and the U-shaped snap-engaging sleeve (7) is snap-engaged on the circuit board (6) through the snap-engaging openings (1).

3. The folding electronic card with secured switch connection according to claim 1, wherein the insulation sheet (8) is a PVC film.

4. The folding electronic card with secured switch connection according to claim 1, wherein the circuit board (6) is further provided with a button battery (5) and a speaker (3).

5. The folding electronic card with secured switch connection according to claim 4, wherein a hollow is provided at a position of the U-shaped snap-engaging sleeve (7) corresponding to the contact plate (2).

## Patentansprüche

1. Elektronische Faltkarte mit gesicherter Schaltverbindung, die eine Schaltplatine (6) und eine Isolierhülle (8) enthält, ferner eine Kontaktplatte (2) und eine elastische Folie (4) umfassend, die auf der Schaltplatine (6) vorgesehen ist und als Schalter fungiert, wobei die elastische Folie (4) federnd gegen die Kontaktplatte (2) gedrückt wird, wobei die Isolierhülle (8) zwischen der Kontaktplatte (2) und der elastischen Folie (4) verschiebbar ist, wobei die elektronische Faltkarte **dadurch gekennzeichnet ist, dass** sie ferner eine U-förmige einrastende Hülse (7) umfasst, die auf der Schaltplatine (6) vorgesehen ist und sich oberhalb der Kontaktplatte (2) und der elastischen Folie (4) befindet, wobei die Isolierhülle (8) gleitend in die U-förmige einrastende Hülse (7) eingeführt wird, wobei ein Ende der Isolierhülle (8) mit einem Durchgangsloch versehen ist, wobei die Schaltplatine (6) und ein festes Ende der Isolierhülle (8) an zwei Seiten der elektronischen Faltkarte befestigt sind, und wenn die elektronische Faltkarte aufgeklappt wird, gleitet ein bewegliches Ende der Isolierhülle (8), sodass die Kontaktplatte (2) und die elastische Folie (4) durch das Durchgangsloch in Kontakt miteinander sind, und wenn die Karte gefaltet wird, gleitet das bewegliche Ende der Isolierhülle (8) zwischen der Kontaktplatte (2) und der elastischen Folie (4), sodass die Kontaktplatt (2) und die elastische Folie (4) voneinander durch die Isolierhülle (8) getrennt werden.

2. Elektronische Faltkarte mit gesicherter Schaltverbindung nach Anspruch 1, wobei die Schaltplatine (6) mit zwei einrastenden Öffnungen (1) auf zwei entgegengesetzten Seiten der Kontaktplatte (2) versehen ist, und die U-förmige einrastende Hülse(7) ist auf der Schaltplatine (6) durch die einrastenden Öffnungen (1) eingerastet.

3. Elektronische Faltkarte mit gesicherter Schaltverbindung nach Anspruch 1, wobei die Isolierhülle (8) ein PVC-Film ist.

4. Elektronische Faltkarte mit gesicherter Schaltverbindung nach Anspruch 1, wobei die Schaltplatine (6) ferner mit einer Knopfbatterie (5) und einem Lautsprecher (3) versehen ist.

5. Elektronische Faltkarte mit gesicherter Schaltverbindung nach Anspruch 4, wobei ein Hohlraum an einer Stelle der U-förmigen einrastenden Hülse (7) vorgesehen ist, der der Kontaktplatte (2) entspricht.

## Revendications

1. Carte électronique pliante avec une connexion de commutation sécurisée, comprenant une carte de circuit (6) et une feuille isolante (8) ; comprenant en outre une plaquette de contact (2) et une feuille élastique (4) disposées sur la carte de circuit (6) et agissant comme un commutateur, la feuille élastique (4) étant pressée élastiquement contre la plaquette de contact (2), la feuille isolante (8) pouvant coulisser entre la plaquette de contact (2) et la feuille élastique (4) ; la carte électronique pliante étant **caractérisée en ce qu'**elle comprend en outre
un manchon encliquetable en forme de U (7) disposé sur la carte de circuit (6) et situé au-dessus de la plaquette de contact (2) et de la feuille élastique (4), la feuille isolante (8) étant insérée de façon coulissante dans le manchon encliquetable en forme de U (7), une extrémité de la feuille isolante (8) étant pourvue d'un trou de passage, la carte de circuit (6) et une extrémité fixe de la feuille isolante (8) étant fixées sur deux côtés de la carte électronique pliante respectivement ; et lorsque la carte électronique pliante est dépliée, une extrémité mobile de la feuille isolante (8) coulisse de telle façon que la plaquette de contact (2) et la feuille élastique (4) sont en contact l'une avec l'autre au niveau du trou de passage, et lorsque la carte est pliée, l'extrémité mobile de la feuille isolante (8) coulisse entre la plaquette de contact (2) et la feuille élastique (4) de telle façon que la plaquette de contact (2) et la feuille élastique (4) sont isolées l'une de l'autre par la feuille isolante (8).

2. Carte électronique pliante avec une connexion de commutation sécurisée selon la revendication 1, dans laquelle la carte de circuit (6) est pourvue de deux ouvertures d'encliquetage (1) sur deux côtés opposés de la plaquette de contact (2) respectivement, et le manchon encliquetable en forme de U (7) est encliqueté sur la carte de circuit (6) à travers les ouvertures d'encliquetage (1).

3. Carte électronique pliante avec une connexion de commutation sécurisée selon la revendication 1, dans laquelle la feuille isolante (8) est un film de PVC.

4. Carte électronique pliante avec une connexion de commutation sécurisée selon la revendication 1, dans laquelle la carte de circuit (6) est en outre dotée d'une pile bouton (5) et d'un haut-parleur (3).

5. Carte électronique pliante avec une connexion de commutation sécurisée selon la revendication 4, dans laquelle un creux est disposé à un endroit du manchon encliquetable en forme de U (7) correspondant à la plaquette de contact (2).
